# EUROPÄISCHE PATENTANMELDUNG

(11) **EP 1 354 916 A1**
(43) Veröffentlichungstag der Anmeldung: **22.10.2003**
(21) Anmeldenummer: 02405312.6
(22) Anmeldetag: 17.04.2002
(51) Int. Cl.: C08L 63/02, C09D 163/02, H01B 3/40

(54) **Selbstheilende Epoxidharze für die Herstellung von elektrischen Isolierungen**

(71) Anmelder: ABB RESEARCH LTD., 8050 Zürich (CH)
(72) Erfinder: Wenger, Bernd, 5028 Ueken (CH); Meier, Patrick, 5600 Lenzburg (CH); Rocks, Jens, 8057 Zürich (CH); Dirix, Yvo, 8057 Zürich (CH)
(74) Vertreter: ABB Patent Attorneys

(57) **Zusammenfassung**

Vergussmasse, enthaltend ein an sich bekanntes duroplastisch härtbares Epoxidharz oder ein Gemisch solcher Harze, einen an sich bekannten Härter oder ein Gemisch solcher Härter, und gegebenenfalls Additive, wobei diese Vergussmasse in gleichmässiger Verteilung (a) mindestens eine Siloxanverbindung mit einer Viskosität im Bereich von etwa 0.25 cSt bis etwa 20'000 cSt (gemessen gemäss DIN 53 019 bei 25°C), sowie (b) mindestens ein Fluorotensid, enthält; Verwendung dieser Vergussmasse zur Herstellung von elektrischen Isolierungen und Bauteilen sowie die derart hergestellten elektrischen Isolierungen und Bauteile.

## Beschreibung

### Geltungsbereich

Die vorliegende Erfindung betrifft Vergussmassen auf der Basis duroplastisch härtbarer Epoxidharze für die Herstellung von Formteilen und Beschichtungen, wie beispielsweise selbst heilende elektrische Isolierungen, insbesondere in Form von Formteilen und Beschichtungen auf dem Gebiet der Hochspannungsisolierungen für den Freilufteinsatz sowie die erfindungsgemäss hergestellten Formteile und Beschichtungen.

### Technisches Gebiet

Hochspannungsisolierungen auf Basis duroplastisch härtbarer Epoxidharze für den Freilufteinsatz sind an sich bekannt. Für Freiluftanwendungen werden traditionell Isolatoren auf Basis von Glas und Keramik eingesetzt. Dabei kommen Freiluftisolatoren in grossen Stückzahlen bei Hochspannungsleitungen, als auch im Mittelspannungsbereich, vor allem als Stützisolatoren, zum Einsatz. Weitere Anwendungsgebiete sind Freiluft-Leistungschalter, Messwandler, Durchführungen, Ableiter sowie im Schaltanlagenbau.

Giessharzsysteme auf Basis von Epoxidharzen besitzen keine intrinsische Hydrophobiewiederkehr und weisen zudem eine vergleichsweise niedrigere Hydrophobie auf. Deshalb ist der Einsatz von Epoxidharzen und verwandten Materialien vorwiegend auf die Anwendung in Innenräumen beschränkt. Es besteht aber das Bedürfnis diese Giessharzsysteme derart zu verbessern, dass diese für die Herstellung von elektrischen Isolierungen geeignet sind und eine erhöhte Hydrophobie sowie gleichzeitig auch die Eigenschaft der Hydrophobiewiederkehr aufweisen, ohne dass deren gute mechanische Eigenschaften merklich verändert bzw. geschwächt werden. Derart könnten preisgünstige Epoxidharze für die Herstellung von elektrischen Isolierungen verwendet werden.

### Stand der Technik

Es wurde bereits vorgeschlagen, die guten elektrischen Eigenschaften von Silikonen, wie z.B. von Dimethylsiloxanen, mit den Eigenschaften von Epoxidharzen zu verbinden, bzw. Silikone den Epoxidharzen zuzusetzen. Siloxanverbindungen und Epoxidverbindungen sind in der Regel nicht genügend mit einander mischbar, so dass Stabilisatoren wie oberflächenaktive Mittel oder Mittel, welche die Viskosität des Systems erhöhen, beigemischt werden müssen. Die Stabilisatoren stabilisieren zwar die Zweiphasen Morphologie des Systems; sie senken aber dessen Glasübergangstemperatur und verschlechtern dessen mechanischen Eigenschaften.

### Darstellung der Erfindung

Es wurde nun gefunden, dass eine für die Herstellung von selbst heilenden elektrischen Isolierungen geeignete Epoxid Vergussmasse erhalten wird, wenn man dem Epoxidharz vor der Härtung, d.h. der Epoxidvergussmasse, eine im weiteren definierte Siloxanverbindung sowie ein Fluorotensid, zusetzt.

Dabei bildet sich nach dem Mischen der Komponenten ein stabiles Zweiphasensystem, welches bis nach der Härtung erhalten bleibt, wobei nach der Härtung ein Produkt mit überlegenen mechanischen und elektrischen Eigenschaften erhalten wird im Vergleich zu derselben Vergussmasse, welche keinen oder einen konventionellen Stabilisator enthält. Mit Bezug auf die mechanischen Eigenschaften werden insbesondere verbesserte K_{1C}-Werte erhalten.

Die vorliegende Erfindung ist in den Patentansprüchen definiert. Insbesondere betrifft die vorliegende Erfindung eine härtbare flüssige oder pastöse Vergussmasse, enthaltend ein an sich bekanntes duroplastisch härtbares Epoxidharz oder ein Gemisch solcher Harze, einen an sich bekannten Härter oder ein Gemisch solcher Härter, und gegebenenfalls Additive, welche dadurch gekennzeichnet ist, dass diese in gleichmässiger Verteilung (a) mindestens eine Siloxanverbindung mit einer Viskosität im Bereich von etwa 0.25 cSt bis etwa 20'000 cSt (gemessen gemäss DIN 53 019 bei 25°C), sowie (b) mindestens ein Fluorotensid, enthält.

Die Siloxanverbindung ist eine lineare oder verzweigte Verbindung oder eine Gemisch oligomerer Verbindungen.

Die erfindungsgemässen Vergussmassen sind besonders für die Herstellung von Formteilen und Beschichtungen auf dem Gebiet der elektrischen Isolierungen, insbesondere Hochspannungsisolierungen, insbesondere für den Freilufteinsatz, sowie für zahlreiche andere Einsätze, geeignet.

In diesem Sinne betrifft die vorliegende Erfindung die Verwendung der erfindungsgemässen Vergussmassen für die Herstellung von Formteilen und Beschichtungen auf dem Gebiet der elektrischen Isolierungen, insbesondere Hochspannungsisolierungen, insbesondere Hochspannungsisolierungen für den Freilufteinsatz, sowie für zahlreiche andere Einsätze, wie dies im weiteren beschrieben ist.

Die Erfindung betrifft im weiteren die aus den erfindungsgemässen Vergussmassen hergestellten Formteile, Beschichtungen und Isolierungen. Die Erfindung betrifft im weiteren ein Verfahren zur Herstellung der erfindungsgemässen Vergussmassen.

Die Viskosität der Siloxanverbindung [Komponente (a)] liegt vorzugsweise im Bereich von etwa 1 cSt bis etwa 5'000 cSt, vorzugsweise im Bereich von etwa 2 cSt bis 3'000 cSt, vorzugsweise im Bereich von etwa 5 cSt bis 300 cSt, gemessen gemäss DIN 53 019 bei 25°C.

Die Siloxanverbindung entspricht vorzugsweise der allgemeinen Formel (I): 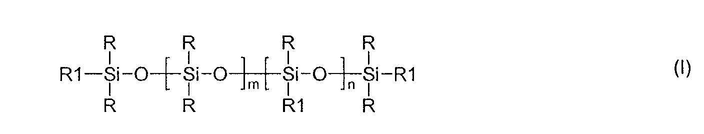 worin
- R: unabhängig voneinander einen gegebenenfalls fluorierten und/oder chlorierten Alkylrest mit 1-4 C-Atomen, oder Phenyl, vorzugsweise Methyl, Ethyl, Propyl, 3,3,3-Trifluoropropyl, Monofluoropropyl, Difluoromethyl oder Phenyl, vorzugsweise Methyl oder einen Rest der Formel

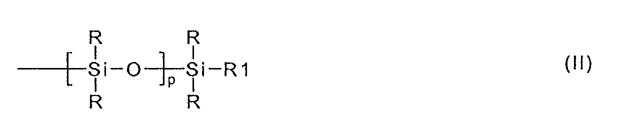

- R₁: unabhängig von einander eine der Bedeutungen von R oder Hydroxyl, oder (C₁-C₄)Alkyl-Epoxid, oder zwei endständige R₁ die direkte Bindung (entsprechend einer cyclischen Verbindung) bilden,
- m: Null oder eine ganze Zahl von 1-1000, vorzugsweise eine ganze Zahl von 2 bis 500, und vorzugsweise etwa 5 bis 100, insbesondere 5-40;
- n: Null oder eine ganze Zahl von 1-50, vorzugsweise 1-20,

- p: Null oder eine ganze Zahl von 1-50, vorzugsweise Null oder 1-20,
bedeuten, wobei (i) die Summe [m+n+p] im Bereich von 1-1000, vorzugsweise im Bereich von 2-500, vorzugsweise 5-100, und insbesondere bei 5-40, liegt und (ii) die Gruppen [-Si(R)(R)O-] und [-Si(R)(R₁)O-] im Molekül in beliebiger Reihenfolge angeordnet sind.

R₁ bedeutet vorzugsweise gegebenenfalls fluoriertes und/- oder chloriertes (C₁-C₄)-Alkyl und vorzugsweise Methyl, oder Hydroxyl, oder C₂-Alkyl-Epoxid (Glycidyl). In diesem Sinne entspricht die Siloxanverbindung vorzugsweise der allgemeinen Formel (Ia) : 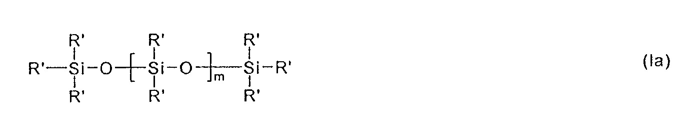 worin R' unabhängig voneinander einen gegebenenfalls fluorierten und/oder chlorierten Alkylrest mit 1-4 C-Atomen, oder Phenyl, vorzugsweise Methyl, Ethyl, Propyl, oder Phenyl, vorzugsweise Methyl oder einen Rest der Formel (IIa): 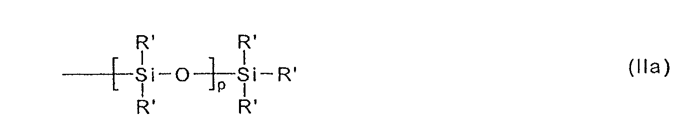 bedeutet und m, n und p die oben angegebene Bedeutung haben; oder der allgemeinen Formel (Ib): 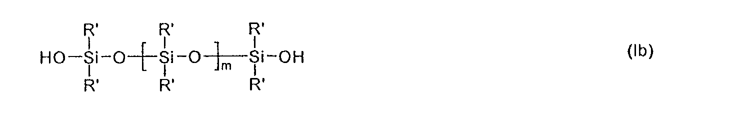 oder der allgemeinen Formel (Ic): 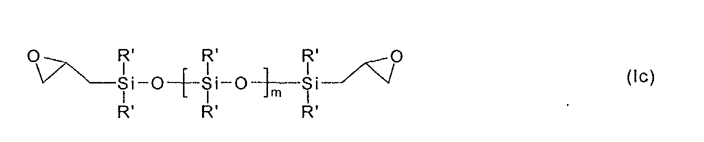 worin R' und m die oben angegebenen Bedeutungen haben.

Ist die Verbindung der Formel (I) eine cyclische Verbindung, so ist diese aus -[Si(R)(R)O]- und/oder -[Si(R)(R₁)O]-Einheiten, zusammengesetzt, welche einen Ring mit vorzugsweise 4 bis 12 solcher Einheiten bilden. Von den ringförmigen Siloxanen sind jedoch die ringförmigen Polysiloxane mit 4 bis 8 Siloxy-Einheiten bevorzugt, insbesondere mit vier bis acht -[Si(R)(R)O]-Einheiten, insbesondere mit vier bis acht -[Si(R')(R')O]-Einheiten, insbesondere 4, 5 oder 6 solcher Einheiten.

Die Herstellung der Verbindungen der Formel (I) ist an sich bekannt oder die Verbindungen können gemäss bekannten analogen Verfahren hergestellt werden. Die Verbindung der Formel (I) stellt in der Regel ein Gemisch von Verbindungen der Formel (I) dar, was dem Fachmann bekannt ist. Vorzugsweise enthält das Gemisch auch cyclische Verbindungen. Vorzugsweise weist das Gemisch jeweils auch einen Gehalt von bis zu 10 Gew.-%, vorzugsweise etwa 6-8 Gew.-% an cyclischen Verbindungen auf, welche nur aus -[Si(R)(R)O]-Einheiten, zusammengesetzt sind, wie cyclische Dimethylsiloxane mit 4-12 Dimethylsiloxyeinheiten, vorzugsweise solche mit 4, 5 oder 6 Dimethylsiloxyeinheiten.

Die erfindungsgemässe Vergussmasse enthält die Polysiloxanverbindung oder das Gemisch dieser Polysiloxanverbindungen, in einer Menge von etwa 0.6-20 Gew.-%, vorzugsweise etwa 2-10 Gew.-% und insbesondere in einer Menge von etwa 3-12 Gew.-%, bezogen auf das Gesamtgewicht des in der Mischung anwesenden Epoxidharzes, d.h. bezogen auf das Gesamtgewicht aller in der Vergussmasse anwesenden Verbindungen, welche mindestens eine Epoxidgruppe pro Molekül aufweisen.

Erfindungsgemäss enthält das Epoxidharz ein Fluorotensid [Komponente (b)]. Ein Tensid besteht in der Regel aus einem hydrophoben Teil und einem hydrophilen Teil. Der hydrophobe Teil ist meist ein Kohlenwasserstoff, wie beispielsweise ein Fettsäurerest; der hydrophile Teil ist anionisch, kationisch, nicht-ionisch oder amphother. Gemäss der vorliegenden Erfindung wird ein Tensid eingesetzt, welches als hydrophoben Rest einen teilweise oder gänzlich fluorierten Kohlenwasserstoffrest und als hydrophilen Teil einen anionischen, kationischen, nicht-ionischen oder amphotheren Rest, aufweist. Ein solches Tensid wird als "Fluorotensid" bezeichnet. Fluorotenside sind an sich bekannt und beispielsweise in US 4,176,176, US 3,993,745 und US 3,993,744 beschrieben. Der Inhalt dieser Patentschriften ist hier mit eingeschlossen (incorporated by reference). Solche Fluorotenside sind im Handel beispielsweise unter den Marken Zonyl® und Fluorad® erhältlich.

Das zu verwendende Fluorotensid entspricht vorzugsweise der allgemeinen Formel (III):

R-[C(R₂)(R₃)-C(R₂)(R₃)]ₓ-A (III),

worin der hydrophobe Rest der allgemeinen Formel (IIIa):

R-[C(R₂)(R₃)-C(R₂)(R₃)]ₓ- (IIIa),

entspricht, und A den hydrophilen Teil des Tensids bezeichnet, worin
R₂ und R₃ unabhängig von einander Wasserstoff oder Fluor, und
x eine ganze Zahl 2-12, vorzugsweise 2-10, vorzugsweise 3-8, und vorzugsweise 3-5, bedeuten.

Bedeutet der hydrophobe Rest der Formel (IIIa) einen teilweise fluorierten Kohlenwasserstoffrest, so bedeutet vorzugsweise die Hälfte, und vorzugsweise etwa 80%, der anwesenden Substituenten R₂ und R₃ unabhängig von einander Fluor. Bevorzugt sind perfluorierte Reste der allgemeinen Formel (IIIa), d.h. Reste worin sämtliche Substituenten R₂ und R₃ Fluor bedeuten.

Der hydrophile Anteil A der Verbindung der allgemeinen Formel (III) entspricht vorzugsweise der allgemeinen Formel (IV) :

-[C(R₄)(R₅)-C(R₄)(R₅)O]_{y}-B (IV),

worin
R₄ und R₅ unabhängig von einander Wasserstoff oder Fluor, vorzugsweise Wasserstoff,
y Null oder eine ganze Zahl im Bereich von 1 bis 10, vorzugsweise Null oder 1 bis 6 und insbesondere Null, 1, 2, 3 oder 4, und
B Wasserstoff oder einen anionischen, kationischen oder amphotheren Rest, bedeuten.

Anionische Reste B der Formel (IV) sind beispielsweise -C(O)OH, -P(O)OH, -P(O)(OH)₂, -S(O)OH, -S(O)₂OH, oder ein Salz davon, oder -(CH₂)_{z}-C(O)OH, -(CH₂)_{z}O-P(O)OH, -(CH₂)_{z}O-P(O)(OH)₂, -(CH₂)_{z}-OS(O)OH, -(CH₂)_{z}O-S(O)₂OH, worin z 1, 2 ,3, oder 4 bedeutet, oder ein Salz davon, vorzugsweise ein Salz von Natrium oder Kalium oder Ammonium.

Kationische Reste B der Formel (IV) sind beispielsweise -CH₂C(O)NHCH₂CH₂[NH(CH₃)CH₂CH₂NH(CH₃)₂]²⁺(Anion)₂, sowie analoge Verbindungen.

Nicht-ionische Reste A der Formel (III) ergeben sich insbesondere, wenn B in der Formel (IV) Wasserstoff bedeutet. Weitere Beispiele sind Verbindungen, worin B einen Acylrest bedeutet, wie beispielsweise [-(O)C-CₙH₂ₙ₊₁], worin n eine Zahl von 1-22 bedeutet. Ein solcher Acylrest kann weitere Substituenten tragen, welche gegebenenfalls den nicht-ionischen Charakter verändern, wie beispielsweise Hydroxyl, Amino oder Carboxyl. Zahlreiche weitere Kombinationen sind denkbar.

Amphothere Reste sind solche, wo B in der Formel (IV) beispielsweise -CH₂CHO(O)CCH₂CH₂N⁺(CH₃)₂CH₂COO⁻, oder -CH₂CHOCH₂C(O)NHCH₂CH₂N⁺(CH₃)₂CH₂COO⁻ bedeutet, sowie weitere solche Kombinationen von kationischen und anionischen Gruppen in dem selben Molekül.

Bevorzugt sind nicht-ionische Verbindungen der Formel (III), insbesondere Verbindungen worin B Wasserstoff bedeutet.

Bevorzugt sind insbesondere nicht-ionische Verbindungen der Formel (V):

F- (CF₂-CF₂)ₓ-CH₂-CH₂O-(CH₂-CH₂O)_{y}-H (V)

worin x und y die oben angegebenen Bedeutungen haben.

Das Fluorotensid [Komponente (b)] verwendet man vorzugsweise in Mengen (berechnet auf das reine Fluorotensid) von 0.1-5.0 Gew.-%, vorzugsweise von 0.5-3.0 Gew.-%, vorzugsweise von etwa 1.0-1.5 Gew.-%, jeweils bezogen auf das Gesamtgewicht der in der Vergussmasse anwesenden Epoxidharzes und Härters.

Das Fluorotensid kann in flüssiger oder pastöser Form, als Feststoff oder gelöst in einem geeigneten Lösungsmittel, vorliegen und in dieser Form direkt verwendet werden. Bemerkenswert ist, dass das Fluorotensid, je nach dessen chemischen Struktur, sowohl mit dem Epoxidharz als auch mit dem Härter zu reagieren vermag. Infolge der geringen Mengen, welche zur Anwendung kommen, kann das Fluorotensid überraschenderweise auch als wässrige Lösung, beispielsweise in einer Konzentration von 40 Gew.-%, verwendet werden, obwohl die Anwesenheit von Wasser in der Verarbeitung von Epoxidharzen an sich unerwünscht ist.

Als Vergussmassen in flüssiger oder pastöser Form kommen erfindungsgemäss duroplastisch härtbare Epoxid-Vergussmassen in Frage. Diese bestehen in der Regel aus dem Epoxidharz, dem Härter und gegebenenfalls dem Beschleuniger sowie weiteren Zusatzstoffen. Bevorzugt sind Epoxidharze mit guten elektrischen Eigenschaften, vorzugsweise auf der Basis von aromatische und/oder cycloaliphatischen Epoxidharzen. Solche in der Elektroindustrie verwendete Epoxidharze sind an sich aus der Literatur bekannt und können erfindungsgemäss verwendet werden. Zahlreiche Publikationen existieren auch zu den elektrischen Araldit®-Giessharzsystemen der Ciba SC AG.

Als Epoxidharz sind vernetzend wirkende Glycidylverbindungen, welche mindestens zwei 1,2-Epoxidgruppen im Molekül aufweisen, bevorzugt. Vorzugsweise verwendet man ein Gemisch von Polyglycidylverbindungen, beispielsweise ein Gemisch von Diglycidyl- und Triglycidylverbindungen. Solche Verbindungen sind an sich bekannt und in der Literatur ausführlich beschrieben. In der Regel kann aus den bekannten Glycidylverbindungen eine für die vorgesehene elektrische Anwendung geeignete Auswahl getroffen werden, was für den Fachmann ein Optimierungsproblem darstellt.

Geeignete Glycidylverbindungen sind beispielsweise in EP-A-0 297 030 beschrieben. Diese umfassen Verbindungen, die unsubstituierte Glycidylgruppen und/oder mit Methylgruppen substituierte Glycidylgruppen aufweisen. Die Glycidylverbindungen haben vorzugsweise ein Molekulargewicht zwischen 200 und 1200, insbesondere zwischen 200 und 1000 und können fest oder flüssig sein. Ihr Epoxidgehalt beträgt vorzugsweise mindestens drei Äquivalente pro Kilogramm der Verbindung, vorzugsweise mindestens vier Äquivalente pro Kilogramm und insbesondere mindestens fünf Äquivalente pro Kilogramm. Bevorzugt sind Glycidylverbindungen, die Glycidylether- und/oder Glycidylestergruppen aufweisen. Eine Glycidylverbindung kann dabei auch beide Arten von Glycidylgruppen enthalten, wie z.B. 4-Glycidyloxybenzoesäureglycidylester. Bevorzugt sind Polyglycidylester mit 1-4 Glycidylestergruppen, insbesondere Diglycidylester und/oder Triglycidylester. Die bevorzugten Diglycidylester leiten sich vorzugsweise von aromatischen, araliphatischen, cycloaliphatischen, heterocyclischen, heterocyclisch-aliphatischen oder heterocyclisch-aromatischen Dicarbonsäuren mit 6 bis 20, insbesondere 6 bis 12 Ringkohlenstoffatomen oder von aliphatischen Dicarbonsäuren mit 2 bis 10 Kohlenstoffatomen ab. Solche Verbindung sind beispielsweise unter dem Handelsnamen Araldit® (Ciba SC AG) kommerziell erhältlich. Bevorzugt sind beispielsweise die an sich bekannten Epoxidharze auf Basis mehrwertiger aromatischer oder cycloaliphatischer Hydroxylverbindungen.

Insbesondere geeignet sind gegebenenfalls substituierte Epoxidharze der Formel (VIa): 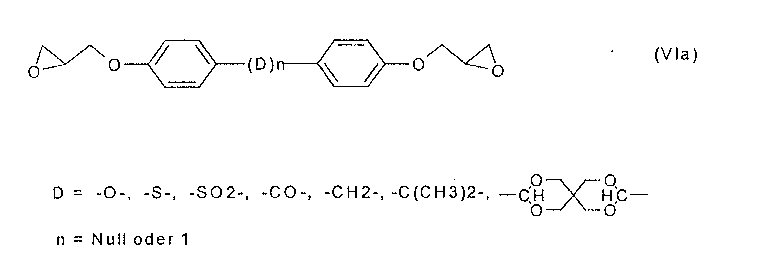 auf der Basis von aromatischen Hydroxylverbindungen. Beispiele sind Glycidylether von Bisphenol A oder Bisphenol F sowie die Glycidylether von Phenol-Novolak-Harzen oder Kresol-Novolak-Harzen.

Cycloaliphatische Epoxidharze sind z.B. Hexahydro-o-phthalsäure-bis-glycidylester, Hexahydro-m-phthalsäure-bis-glycidylester oder Hexahydro-p-phthalsäure-bis-glycidylester. Auch aliphatische Epoxidharze, wie z.B. 1,4-Butandioldiglycidylether, sind für die erfindungsgemässe Verwendung geeignet.

Bevorzugte Epoxidharze mit guten elektrischen Eigenschaften sind auch aromatische und/oder cycloaliphatische Epoxidharze, welche mindestens eine Aminoglycidylgruppe im Molekül enthalten. Solche in der Elektroindustrie verwendeten Epoxidharze sind an sich aus der Literatur bekannt und beispielsweise in WO 99/67315 beschrieben.

Bevorzugt sind Verbindungen der allgemeinen Formel (VIb):

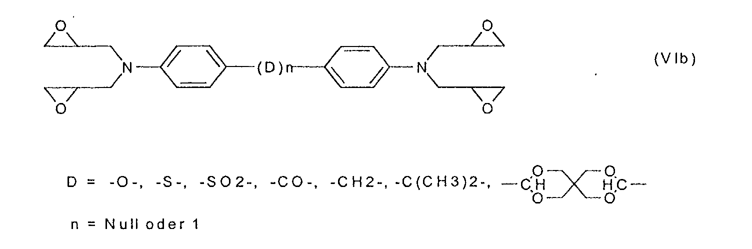

Besonders geeignete Aminoglycidylverbindungen sind N,N-Diglycidylanilin, N,N-Diglycidyltoluidin, N,N,N',N'-Tetraglycidyl-1,3-diaminobenzol, N,N,N',N'-Tetraglycidyl-1,4-diaminobenzol, N,N,N',N'-Tetraglycidylxylylendiamin, N,N,N',N'-Tetraglycidyl-4,4'-diaminodiphenylmethan, N,N,N',N'-Tetraglycidyl-3,3'diethyl-4,4'-diaminodiphenylmethan, N,N,N',N'-Tetraglycidyl-3,3'-diaminodiphenylsulfon, N,N'-Dimethyl-N,N'-diglycidyl-4,4'-diaminodiphenylmethan, N,N,N',N'-Tetraglycidyl-alfa,alfa'-bis(4-aminophenyl)-p-diisopropylbenzol und N,N,N',N'-Tetraglycidyl-alfa,alfa'-bis-(3,5-dimethyl-4-aminophenyl)-p-diisopropylbenzol. Bevorzugte Aminoglycidylverbindungen entsprechen auch der Formel (VIc) : 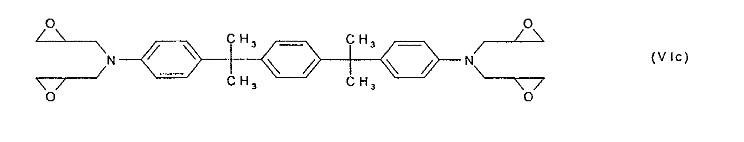 oder der Formel (VId) :

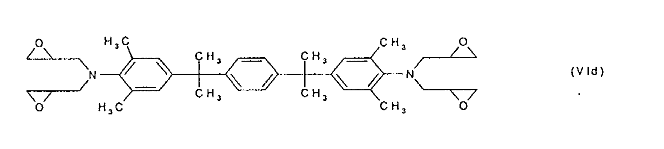

Geeignete Polyglycidylverbindungen von Aminophenolen sind auch O,N,N-Triglycidyl-4-aminophenol, O,N,N-Triglycidyl-3-aminophenol und 2,2-(N,N-Diglycidyl-4-aminopheny-1,4'-glycidyloxyphenyl)-propan.

Als Härter verwendet man an sich bekannte hydroxylhaltige Verbindungen und/oder carboxylhaltige Polymere, insbesondere carboxylterminierte Polyester und/oder carboxylhaltige Acrylat- und/oder Methacrylatpolymere und/oder Carbonsäureanhydride. Solche Härter sind an sich bekannt. Geeignete Härter sind auch cyclische Anhydride von aromatischen, aliphatischen, cycloaliphatischen und heterocyclischen Polycarbonsäuren. Besonders geeignete Anhydride von aromatischen Polycarbonsäuren sind Phthalsäureanhydrid und deren substituierte Derivate, Benzol-1,2,4,5-tetracarbonsäuredianhydrid (Pyromellithsäuredianhydrid) und deren substituierte Derivate, sowie Verbindungen der Formel (VII):

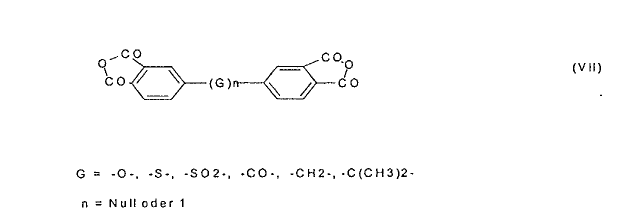

Als Härter geeignete Anhydride sind beispielsweise Phthalsäureanhydrid, 4-Methylphthalsäureanhydrid, 3,6-Dichlorphthalsäureanhydrid, 4,5-Dichlorphthalsäureanhydrid, 3,6-Difluorphthalsäureanhydrid, Tetrabrom-, Tetrachlor- und Tetrafluorphthalsäureanhydrid, 3-Nitro- und 4-Nitro-phthalsäureanhydrid, Benzol-1,2,4,5-tetracarbonsäuredianhydrid (Pyromellithsäuredianhydrid), 3,3',4,4'-Benzophenontetracarbonsäuredianhydrid, 2,2-Bis(3,4-benzoldicarboxyphenyl)-propan-dianhydrid, 2,2-Bis(2,3-benzoldicarboxyphenyl)-propandianhydrid, 2,2-Bis(4,4-benzoldicarbonsäureanhydrid)perfluorpropan, Bis(3,4-dicarboxyphenyl)etherdianhydrid, Bis-(3,4-dicarboxylphenyl)methandianhydrid, 2,2',3,3-Diphenyltetracarbonsäuredianhydrid und 3,3',4,4'-Diphenyltetracarbonsäuredianhydrid. Die aromatischen Carbonsäureanhydride können zusätzliche funktionelle Gruppen enthalten. Beispiele sind Benzol-1,2,4-tricarbonsäure-anhydrid (Trimellithsäureanhydrid), 3-Hydroxyphthalsäureanhydrid, 3-bzw. 4-Maleinimidophthalsäureanhydrid sowie das 2-Sulfobenzoesäure-cyclo-anhydrid. Geeignet sind auch Derivate des Trimellithsäureanhydrids wie z.B. das Bistrimellithsäureanhydrid des Neopentylglykols.

Ebenso sind aromatische Carbonsäureanhydride mit kondensierten Ringsystemen geeignet, wie z.B. 1,8-Naphthalsäureanhydrid, Naphthalin-1,4,5,8-tetracarbonsäuredianhydrid, Naphthalin-1,2,5,6-tetracarbonsäuredianhydrid, Naphthalin-3,4,5,8-tetracarbonsäuredianhydrid, Naphthalin-2,3,6,7-tetracarbonsäuredianhydrid, 3,4,9,10-Perylentetracarbonsäuredianhydrid und ihre Halogen und Nitroderivate.

Besonders bevorzugt ist Maleinsäureanhydrid und Derivate von Maleinsäureanhydrid. Diese sind als alleiniges Härtungsmittel für Aminoglycidylharze und für ihre Mischungen mit anderen Epoxidharzen verwendbar.

An sich bekannte Cycloaliphatische Dicarbonsäureanhydride, wie z.B. cis-Cyclohexan-1,2-dicarbonsäureanhydrid und verwandte Verbindungen, bicyclische Verbindungen, wie bicyclische cycloaliphatische Dicarbonsäureanhydride, heterocyclische Carbonsäureanhydride, können ebenso verwendet werden.

Das Härtungsmittel verwendete man in an sich bekannten Konzentrationen im Bereich von 0,4 bis 1,2, vorzugsweise 0.8 bis 1.2, Äquivalente der reaktiven Härtergruppe, z.B. Anhydridgruppe, per 1 Epoxidäquivalent eingesetzt.

Die erfindungsgemässen härtbaren Mischungen können Zusatzstoffe, wie an sich bekannte Beschleuniger, Füllstoffe, Plastifizierungsmittel, Elastifizierungsmittel, Zähigkeitsvermittler, Antioxidantien, Lichtschutzmittel, Weichmacher, Thixotropiemittel, Entschäumer, Antistatika, Gleitmittel und Entformungshilfsmittel, Flammschutzmittel, Farbstoffe und/oder Verstärkungsfasern enthalten. Bevorzugt kommen Vergussmassen zum Einsatz, welche mindestens einen Füllstoff enthalten.

Füllstoffe werden in an sich bekannten Mengen zugesetzt und sind beispielsweise, Holzmehl, Glaspulver, Halbmetall- und Metalloxide, wie zum Beispiel Siliziumdioxid (Aerosile, Quarz, Quarzmehl, Quarzgutmehl), Aluminiumoxid, Titanoxid, Metallhydroxide, [Mg(OH)₂, Al(OH)₃, AlO(OH)], Halbmetallund Metallnitride, wie Siliziumnitrid, Bornitrid und Aluminiumnitrid, Halbmetall- und Metallcarbide, wie Siliziumcarbid (SiC), Metallcarbonate (Dolomit, Kreide, CaCO₃), Metallsulfate (Baryt, Gips), Gesteinsmehle und natürliche oder synthetische Mineralien hauptsächlich aus der Silikatreihe, wie zum Beispiel Zeolithe (insbesondere Molekularsiebe) Talkum, Glimmer, Kaolin, Wollastonit, Bentonit, Dolomit. Bevorzugt sind Quarzmehl, Wollastonit, Aluminiumoxid und/oder Dolomit in verschiedenen an sich bekannten Mahlungen. Die Füllstoffe können mit einer Silanisierung versehen sein, um eine optimale chemische Anbindung der Partikel in der Harzmatrix zu gewährleisten.

Geeignete Zähigkeitsvermittler sind beispielsweise an sich bekannte Core/Shell-Polymere oder als "Rubber Toughener" bezeichnete Elastomere oder Elastomere enthaltende Pfropfpolymere oder auch vernetzte Silikonpolymere.

Härtungsbeschleuniger sind beispielsweise tertiäre Amine, wie Benzyldimethylamin oder Amin-Komplexe, insbesondere Komplexe von tertiären Aminen, mit Bortrichlorid oder Bortrifluorid; Harnstoffderivate, wie z.B. N-4-Chlorphenyl-N',N'-dimethylharnstoff (Monuron); gegebenenfalls substituierte Imidazole, wie Imidazol oder 2-Phenylimidazol. Bevorzugt sind tertiäre Amine.

Für die Herstellung der erfindungsgemässen Vergussmasse kann man das Epoxidharz, den Härter, und die Siloxanverbindung, das Fluorotensid, sowie gegebenenfalls anwesende Additive, wie Beschleuniger, Füllstoffe und weitere Zusatzstoffe, in beliebiger Reihenfolge mischen. Weist die Siloxanverbindung eine reaktive Gruppe auf, wie eine Hydroxylgruppe oder eine Epoxidgruppe, so mischt man die Siloxanverbindung vorzugsweise zumindest teilweise zuerst mit dem Epoxidharz, falls diese eine Epoxidgruppe aufweist und zuerst mit dem Härter, falls die Siloxanverbindung eine Hydroxylgruppe aufweist. Anschliessend stellt man mit dieser Vormischung die Vergussmasse her. Die Vormischung wirkt sich positiv auf die Verteilung des Polysiloxans in der Vergussmasse und somit auch auf die physikalischen und mechanischen Eigenschaften des gehärteten Produktes aus.

Die Härtung der erfindungsgemässen Vergussmasse erfolgt bei an sich bekannten Temperaturen, vorzugsweise im Bereich von 50°C bis 180°C, vorzugsweise bei 80°C bis 120°C. Die Härtung der erfindungsgemässen Vergussmasse ist aber in der Regel auch bei niedrigeren Temperaturen möglich, z.B. bei Raumtemperatur, wobei bei einer Aushärtung bei Raumtemperatur ein Zeitraum von wenigen Tagen bis zu wenigen Wochen nötig ist, um eine vollständige Aushärtung zu erreichen.

Die erfindungsgemässen Vergussmassen werden insbesondere für die Herstellung von Hochspannungsisolierung für den Freilufteinsatz verwendet, insbesondere für die Herstellung von Freiluftisolatoren bei Hochspannungsleitungen als Langstab-, Verbund- und Kappenisolatoren sowie für Stützisolatoren im Mittelspannungsbereich. Die erfindungsgemässen Vergussmassen können auch in der Herstellung Isolierungen bei Freiluft-Leistungschaltern, Messwandlern, Durchführungen und Ableitern, im Schaltanlagenbau, in Leistungsschaltern, Trockentransformatoren und elektrischen Maschinen, Verwendung finden. Im weiteren können die erfindungsgemässen Vergussmassen auch als Beschichtungsmaterialien für Transistoren und andere Halbleiterelemente und ganz allgemein zum Imprägnieren von elektrischen Bauteilen verwendet werden. Ebenso kann die erfindungsgemässe Vergussmasse als Klebstoff, als Matrixharz für faserverstärkte Kunststoffe, als Korrosionsschutz für metallische Bauteile, z.B. für Brücken und Industrieanlagen, verwendet werden, wobei beispielsweise der Glanz der Schicht auch mit der Alterung nicht verloren geht. Die folgenden Beispiele erläutern die Erfindung.

### Testmethoden

Von den im weiteren beschriebenen Prüflingen wurden (i) die Bruchfestigkeit (double torsion fracture test) gemäss dem Ciba-Geigy-Standart, bzw. der kritischen Spannungsintensitätsfaktor (critical stress intensity factor) (K_{1C}) ; [Mpam^{0.5}], die Bruchenergie (energy release rate) (G_{1C}); [J/m²] und die Glasübergangstemperatur (°C) sowie (ii) die Hydrophobie und die Hydrophobiewiederkehr gemessen.

Zur Prüfung der Hydrophobie bzw. der Hydrohobiewiederkehr werden die Prüfkörper einer elektrischen Corona-Entladung während einer Zeitdauer von mindestens 20 Minuten, vorzugsweise etwa 60 Minuten, ausgesetzt. Dabei wird vorübergehend die Oberflächenhydrophobie vermindert oder gänzlich zerstört, worauf anschliessend eine Hydrophobie-Erholung einsetzt. Die Hydrophobie wird in an sich bekannter Weise mit dem Dynamischen Vorrückwinkel mit Wasser in Graden gemessen. Je grösser der Vorückwinkel, um so höher ist die Hydrophobie.

### Beispiel 1

100 Teile des cycloaliphatischen Epoxidharzes CY184 (der Firma Vantico Ltd., Epoxidzahl: 5.9 val/kg, vorwiegend bestehend aus Hexahydro-m-phthalsäure-bis-glycidylester), 90 Teile Hexahydrophtalsäureanhydrid (cis-Cyclohexan-1,2-dicarbonsäureanhydrid (Anhydridhärter HT 907 der Firma Vantico Ltd.), 3 Teile des Härtungsbeschleuniger DY062 (der Firma Vantico Ltd., chem. Formel: Ph-CH₂-N(CH₂CH₃)₂) werden mit 2.4 Teilen des flüssigen linearen (mit Trimethylsilylgruppen terminiertem) Dimethylsiloxans AK 10 (der Firma Wacker-Chemie GmbH) mit durchschnittlich etwa 10-20 Dimethylsiloxyeinheiten und einer Viskosität von etwa 10 cSt und 2.4 Teilen des Fluorotensids Zonyl® FS300 (entsprechend etwa 0.9 Gew.-% Trockensubstanz), d.i. eine Verbindung der Formel F(CF₂-CF₂)ₓ-CH₂CH₂O(CH₂CH₂O)_{y}H, worin x durchschnittlich im Bereich von 3-8, insbesondere bei etwa 4-5 und y durchschnittlich im Bereich von 1-3, und etwa bei 2, liegt, gemischt. Zonyl® FS300 ist eine wässrige Lösung enthaltend etwa 40 Gew.-% an Trockensubstanz. Diese Mischung wird nun in einem Ultra-Turrax Hochgeschwindigkeits-Mischer während 5 Minuten bei 4'000 Umdrehungen pro Minute bis zur gleichmässigen Verteilung gemischt. Es werden keine weiteren Additive zugesetzt.

Die derart erhaltene Vergussmasse ist ein bei Raumtemperatur stabiles Zweiphasensystem. Die Vergussmasse wird nun in einem Rezipienten evakuiert (10 Minuten bei <50 mbar) und in eine auf 80°C heisse Giessform aus Stahl unter Vakuum vergossen. Nach einer Gelierzeit von 8 Stunden bei 80°C werden die Prüfkörper der Giessform entnommen und bei 140°C während 10 Stunden nachgehärtet. Die Analyse mittels Scanning Electron Mikroskopie (SEM) zeigt, dass die Zweiphasenmorpholgie erhalten geblieben ist. Dabei erhält man eine 4 mm dicke Platte, welche zu Prüfkörpern verarbeitet wird.

### Beispiel 2

Beispiel 1 wird wiederholt, mit der Massgabe, dass 4.8 Teile des flüssigen Dimethylsiloxans AK 10 (der Firma Wacker-Chemie Ltd) und 4.8 Teilen des Fluorotensids Zonyl® FS300 (entsprechend etwa 1.92 Gew.-% Trockensubstanz) mit dem Epoxidharz vermischt werden.

### Beispiel 3 (Vergleichsbeispiel)

Beispiel 1 wird wiederholt mit der Massgabe, dass auf die Zugabe des flüssigen Dimethylsiloxans AK 10 und die Zugabe des Fluorotensids Zonyl® FS300 verzichtet wird.

Von den erhaltenen Prüflingen gemäss Beispiel 1, Beispiel 2 und Beispiel 3 sind die gemessenen Werte für den critical stress intensity factor (K_{1C}) ; [Mpam^{0.5}], die energy release rate (G_{1C}) ; [J/m²] und die Glasübergangstemperatur (°C) in Tabelle 1 aufgelistet. Die Werte für die Hydrophobie und die Hydrophobiewiederkehr sind in Tabelle 2 wieder gegeben.

**Tabelle 1**

| | critical stress intensity factor (K_{IC}) ; [Mpam^{0.5}] | energy release rate (G_{IC}) ; [J/m²] | Glass transition temperature (°C) |
|---|---|---|---|
| Beispiel 1 | 1.31 | 399.4 | 89 |
| Beispiel 2 | 1.86 | 905.2 | 85 |
| Beispiel 3 | 0.79 | 142.8 | 107 |

**Tabelle 2**

| | Dynamischer Vorrückwinkel (Wasser, in °) Prüfkörper aus Beispiel 1 | Dynamischer Vorrückwinkel (Wasser, in °) Prüfkörper aus Beispiel 3 |
|---|---|---|
| Grundhydrophobie (ohne Corona-Entladung | 98 | 109 |
| Grundhydrophobie (nach 1. Corona-Entladung) | 0 | 0 |
| Hydrophobie nach 70 h (nach 1. Corona-Entladung) | 56 | 72 |
| Hydrophobie nach 120 h (nach 1. Corona-Entladung) | 58 | 73 |
| Hydrophobie nach 400 h (nach 1. Corona-Entladung) | 69 | 85 |
| Grundhydrophobie (nach 2. Corona-Entladung) | 0 | 0 |
| Hydrophobie nach 70 h (nach 2. Corona-Entladung) | 61 | 77 |
| Hydrophobie nach 120 h (nach 2. Corona-Entladung) | 59 | 78 |
| Hydrophobie nach 400 h (nach 2. Corona-Entladung) | 69 | 87 |

### Beispiel 4

Beispiel 1, Beispiel 2 und Beispiel 3 werden wiederholt mit der Massgabe, dass jeweils Beispiel 1, Beispiel 2 und Beispiel 3 mit 320 Teilen Silica W10 (der Firma Quarzwerke GmbH, Frechen), d.i. ein silanisiertes Quarzmehl, nach dem Herstellen der Emulsion mit einem Propellerrührer zugegeben und gleichmässig vermischt wird. Die derart modifizierte Zusammensetzung aus Beispiel 1 wird hier als Beispiel 1A, aus Beispiel 2 als Beispiel 2A und aus Beispiel 3 als Beispiel 3A bezeichnet.

Von den erhaltenen Prüflingen gemäss Beispiel 1A, Beispiel 2A und Beispiel 3A sind die gemessenen Werte für den critical stress intensity factor (K_{IC}) ; [Mpam^{0.5}], die energy release rate (G_{IC}) ; [J/m²] und die Glasübergangstemperatur (°C) in Tabelle 3 aufgelistet. Die Werte für die Hydrophobie und die Hydrophobiewiederkehr sind in Tabelle 4 wieder gegeben.

**Tabelle 3**

| | critical stress intensity factor (K_{IC}) ; [Mpam^{0.5}] | Crit. energy release rate (G_{IC}) ; [J/m²] | Glass transition temperature (°C) |
|---|---|---|---|
| Beispiel 1A | 2.78 | 659 | 93 |
| Beispiel 2A | 3.25 | 844.6 | 88 |
| Beispiel 3A | 2.49 | 595.9 | 104 |

**Tabelle 4**

| | Dynamischer Vorrückwinkel (Wasser, in °) Prüfkörper aus Beispiel 1 | Dynamischer Vorrückwinkel (Wasser, in °) Prüfkörper aus Beispiel 3 |
|---|---|---|
| Grundhydrophobie (ohne Corona-Entladung | 109 | 105 |
| Grundhydrophobie (nach 1. Corona-Entladung) | 0 | 0 |
| Hydrophobie nach 100 h (nach 1. Corona-Entladung) | 82 | 72 |
| Hydrophobie nach 400 h (nach 1. Corona-Entladung) | 95 | 86 |
| Grundhydrophobie (nach 2. Corona-Entladung) | 0 | 0 |
| Hydrophobie nach 100 h (nach 2. Corona-Entladung) | 78 | 63 |
| Hydrophobie nach 400 h (nach 1. Corona-Entladung) | 89 | 77 |

## Patentansprüche

1. Vergussmasse, enthaltend ein an sich bekanntes duroplastisch härtbares Epoxidharz oder ein Gemisch solcher Harze, einen an sich bekannten Härter oder ein Gemisch solcher Härter, und gegebenenfalls Additive, **dadurch gekennzeichnet, dass** diese Vergussmasse in gleichmässiger Verteilung (a) mindestens eine Siloxanverbindung mit einer Viskosität im Bereich von etwa 0.25 cSt bis etwa 20'000 cSt (gemessen gemäss DIN 53 019 bei 25°C), sowie (b) mindestens ein Fluorotensid, enthält.

2. Vergussmasse nach Anspruch 1, **dadurch gekennzeichnet, dass** die Viskosität der Siloxanverbindung [Komponente (a)] im Bereich von etwa 1 cSt bis etwa 5'000 cSt, vorzugsweise im Bereich von etwa 2 cSt bis 3'000 cSt, vorzugsweise im Bereich von etwa 5 cSt bis 300 cSt, liegt, gemessen gemäss DIN 53 019 bei 25°C.

3. Vergussmasse nach Anspruch 1 oder 2, **dadurch gekennzeichnet, dass** die Siloxanverbindung der allgemeinen Formel (I) : 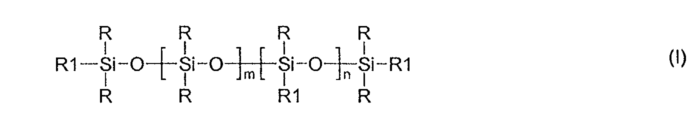 entspricht, worin
R unabhängig voneinander einen gegebenenfalls fluorierten und/oder chlorierten Alkylrest mit 1-4 C-Atomen, oder Phenyl, vorzugsweise Methyl, Ethyl, Propyl, 3,3,3-Trifluoropropyl, Monofluoropropyl, Difluoromethyl oder Phenyl, vorzugsweise Methyl oder einen
Rest der Formel 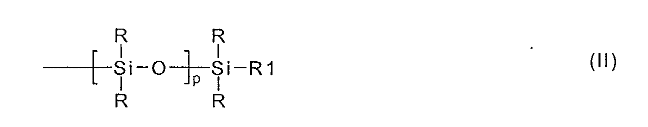
R₁ unabhängig von einander eine der Bedeutungen von R oder Hydroxyl, oder (C₁-C₄)Alkyl-Epoxid, oder zwei endständige R₁ die direkte Bindung (entsprechend einer cyclischen Verbindung) bilden,
m Null oder eine ganze Zahl von 1-1000, vorzugsweise eine ganze Zahl von 2 bis 500, und vorzugsweise etwa 5 bis 100, insbesondere 5-40;
n Null oder eine ganze Zahl von 1-50, vorzugsweise 1-20,
p Null oder eine ganze Zahl von 1-50, vorzugsweise Null oder 1-20,
bedeuten, wobei (i) die Summe [m+n+p] im Bereich von 1-1000, vorzugsweise im Bereich von 2-500, vorzugsweise 5-100, und insbesondere bei 5-40,liegt und (ii) die Gruppen [-Si(R)(R)O-] und [-Si(R)(R₁)O-] im Molekül in beliebiger Reihenfolge angeordnet sind.

4. Vergussmasse nach Anspruch 3, **dadurch gekennzeichnet, dass** R₁ gegebenenfalls fluoriertes und/oder chloriertes (C₁-C4)-Alkyl und vorzugsweise Methyl, oder Hydroxyl, oder C₂-Alkyl-Epoxid (Glycidyl) bedeutet.

5. Vergussmasse nach Anspruch 3 oder 4, **dadurch gekennzeichnet, dass** die Siloxanverbindung der allgemeinen Formel (Ia) : 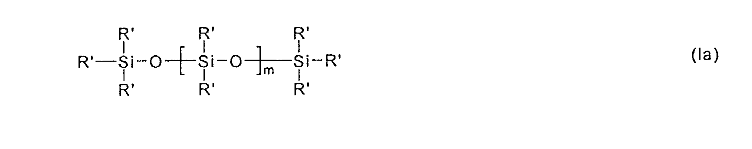 entspricht, worin R' unabhängig voneinander einen gegebenenfalls fluorierten und/oder chlorierten Alkylrest mit 1-4 C-Atomen, oder Phenyl, vorzugsweise Methyl, Ethyl, Propyl, oder Phenyl, vorzugsweise Methyl oder einen Rest der Formel (IIa) : 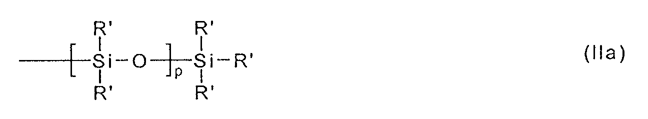 bedeutet, und m, n und p die in Anspruch 3 angegebene Bedeutung haben.

6. Vergussmasse nach Anspruch 3, **dadurch gekennzeichnet, dass** die Siloxanverbindung der allgemeinen Formel (Ib): 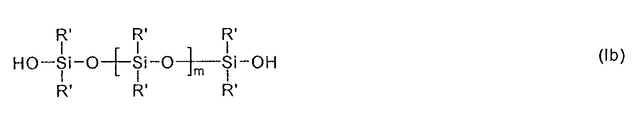 oder der allgemeinen Formel (Ic): 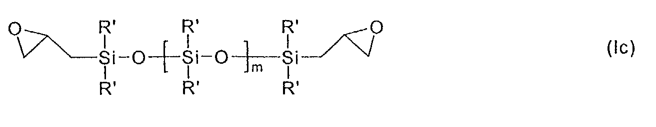 entspricht, worin R' und m die in Anspruch 5 angegebenen Bedeutungen haben.

7. Vergussmasse nach Anspruch 3, **dadurch gekennzeichnet, dass** die Siloxanverbindung eine cyclische Verbindung der Formel (I) darstellt, welche aus -[Si(R)(R)O]- und/oder-[Si(R)(R₁)O]-Einheiten, zusammengesetzt ist, welche einen Ring mit vorzugsweise 4 bis 12 solcher Einheiten bilden, vorzugsweise eine cyclische Verbindung mit 4 bis 8 Siloxy-Einheiten, insbesondere mit 4 bis 8 -[Si(R)(R)O]-Einheiten, insbesondere mit 4 bis 8 -[Si(R')(R')O]-Einheiten.

8. Vergussmasse nach einem der Ansprüche 3-7, **dadurch gekennzeichnet, dass** die Siloxanverbindung einen Gehalt von bis zu 10 Gew.-%, vorzugsweise etwa 6-8 Gew.-% an cyclischen Verbindungen aufweist, welche nur aus -[Si(R)(R)O]-Einheiten zusammengesetzt sind, vorzugsweise cyclische Dimethylsiloxane mit 4-12 Dimethylsiloxyeinheiten, vorzugsweise solche mit 4, 5 oder 6 Dimethylsiloxyeinheiten.

9. Vergussmasse nach einem der Ansprüche 3-8, **dadurch gekennzeichnet, dass** diese die Polysiloxanverbindung oder das Gemisch dieser Polysiloxanverbindungen, in einer Menge von etwa 0.6-20 Gew.-%, vorzugsweise etwa 2-10 Gew.-% und insbesondere in einer Menge von etwa 3-12 Gew.-%, bezogen auf das Gesamtgewicht aller in der Vergussmasse anwesenden Verbindungen, welche mindestens eine Epoxidgruppe pro Molekül aufweisen, enthält.

10. Vergussmasse nach einem der Ansprüche 1-9, **dadurch gekennzeichnet, dass** das Fluorotensid der allgemeinen Formel (III)
R-[C(R₂)(R₃)-C(R2)(R₃)]ₓ-A (III),
worin der hydrophobe Rest der allgemeinen Formel (IIIa):
R-[C(R₂)(R₃)-C(R2)(R₃)]ₓ- (IIIa),
entspricht, und A den hydrophilen Teil des Tensids bezeichnet, und
R₂ und R₃ unabhängig von einander Wasserstoff oder Fluor, und
x eine ganze Zahl 2-12, vorzugsweise 2-10, vorzugsweise 3-8, und vorzugsweise 3-5, bedeuten.

11. Vergussmasse nach Anspruch 10, **dadurch gekennzeichnet, dass** der hydrophobe Rest der Formel (III) einen teilweise fluorierten Kohlenwasserstoffrest bedeutet, in welchem mindestens die Hälfte, vorzugsweise mindestens 80%, der anwesenden Substituenten R₂ und R₃ unabhängig von einander Fluor bedeuten.

12. Vergussmasse nach Anspruch 10 oder 11 **dadurch gekennzeichnet, dass** der hydrophobe Rest der Formel (III) einen perfluorierten Rest bedeutet.

13. Vergussmasse nach einem der Ansprüche 2-12, **dadurch gekennzeichnet, dass** der hydrophile Anteil A der Verbindung der allgemeinen Formel (III) der allgemeinen Formel (IV):
-[C(R₄)(R₅)-C(R₄)(R₅)O]_{y}-B (IV),
entspricht, worin
R₄ und R₅ unabhängig von einander Wasserstoff oder Fluor, vorzugsweise Wasserstoff,
y Null oder eine ganze Zahl von 1 bis 10, vorzugsweise Null oder 1 bis 6 und insbesondere Null, 1, 2, 3 oder 4, und
B Wasserstoff oder einen anionischen, kationischen oder amphotheren Rest, bedeuten.

14. Vergussmasse nach Anspruch 13, **dadurch gekennzeichnet, dass** der anionische Reste B der Formel (IV) -C(O)OH, -P(O)OH, -P(O)(OH)₂, -S(O)OH, -S(O)₂OH, oder ein Salz davon, oder -(CH₂)_{z}-C(O)OH, -(CH₂)_{z}O-P(O)OH, -(CH₂)_{z}O-P(O)(OH)₂, - (CH₂)_{z}-OS(O)OH, -(CH₂)_{z}O-S(O)₂OH, worin z eine Zahl von 1-4 bedeutet, oder ein Salz davon, vorzugsweise jeweils ein Salz von Natrium oder Kalium oder Ammonium.

15. Vergussmasse nach Anspruch 13, **dadurch gekennzeichnet, dass** der kationische Reste B der Formel (IV) -CH₂C(O)NHCH₂CH₂[NH(CH₃)CH₂CH₂NH(CH₃)₂]²⁺(Anion)₂ bedeutet.

16. Vergussmasse nach Anspruch 13, **dadurch gekennzeichnet, dass** B in der Formel (IV) Wasserstoff oder einen Acylrest, vorzugsweise [-(O)C-CₙH₂ₙ₊₁], welcher weitere Substituenten tragen kann und worin n eine Zahl von 1-22, vorzugsweise Wasserstoff, bedeutet.

17. Vergussmasse nach Anspruch 13, **dadurch gekennzeichnet, dass** B in der Formel (IV) einen amphotheren Rest der Formel -CH₂CHO(O)CCH₂CH₂N⁺(CH₃)₂CH₂COO⁻, oder der Formel -CH₂CHOCH₂C(O)NHCH₂CH₂N⁺(CH₃)₂CH₂COO⁻ bedeutet.

18. Vergussmasse nach Anspruch 10, **dadurch gekennzeichnet, dass** das Fluorotensid der Verbindung der Formel (III):
F-(CF₂-CF₂)ₓ-CH₂-CH₂O-(CH₂-CH₂O)_{y}-H (III)
entspricht, worin x und y die in Anspruch 10 angegebenen Bedeutungen haben.

19. Vergussmasse nach einem der Ansprüche 1-18, **dadurch gekennzeichnet, dass** diese das Fluorotensid [Komponente (b)] in einer Menge (berechnet auf das reine Fluorotensid) von 0.1-5.0 Gew.-%, vorzugsweise von 0.5-3.0 Gew.-%, vorzugsweise von etwa 1.0-1.5 Gew.-%, jeweils bezogen auf das Gesamtgewicht des in der Vergussmasse anwesenden Epoxidharzes und Härters, enthält.

20. Vergussmasse nach einem der Ansprüche 1-19, **dadurch gekennzeichnet, dass** diese mindestens ein Additiv enthält, welches ausgewählt ist aus der Gruppe enthaltend Beschleuniger, Füllstoffe, Plastifizierungsmittel, Elastifizierungsmittel, Zähigkeitsvermittler, Antioxidantien, Lichtschutzmittel, Weichmacher, Thixotropiemittel, Entschäumer, Antistatika, Gleitmittel, Entformungshilfsmittel, Flammschutzmittel, Farbstoffe und Verstärkungsfasern.

21. Vergussmasse nach Anspruch 20, **dadurch gekennzeichnet, dass** diese mindestens einen Füllstoff enthält, welcher ausgewählt ist aus Quarzmehl, Wollastonit, Aluminiumoxid und/oder Dolomit in verschiedenen an sich bekannten Mahlungen, welche gegebenenfalls mit einer Silanisierung versehen sind.

22. Vergussmasse nach Anspruch 20, **dadurch gekennzeichnet, dass** diese als Epoxidharz eine vernetzend wirkende Glycidylverbindung mit mindestens zwei 1,2-Epoxidgruppen im Molekül enthält, vorzugsweise ein Gemisch von Diglycidylund Triglycidylverbindungen, vorzugsweise solche, die sich von aromatischen, araliphatischen, cycloaliphatischen, vorzugsweise Hexahydro-m-phthalsäure-bis-glycidylester, heterocyclischen, heterocyclisch-aliphatischen oder heterocyclisch-aromatischen Dicarbonsäuren mit 6 bis 20, insbesondere 6 bis 12 Ringkohlenstoffatomen oder von aliphatischen Dicarbonsäuren mit 2 bis 10 Kohlenstoffatomen, oder von mehrwertigen aromatischen oder cycloaliphatischen Hydroxylverbindungen ableiten.

23. Vergussmasse nach Anspruch 20, **dadurch gekennzeichnet, dass** diese ein gegebenenfalls substituiertes Epoxidharz der Formel (VIa) : 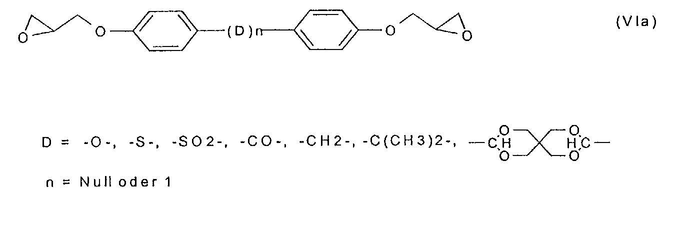 enthält.

24. Vergussmasse nach Anspruch 20, **dadurch gekennzeichnet, dass** diese ein gegebenenfalls substituiertes Epoxidharz der Formel (VIb): 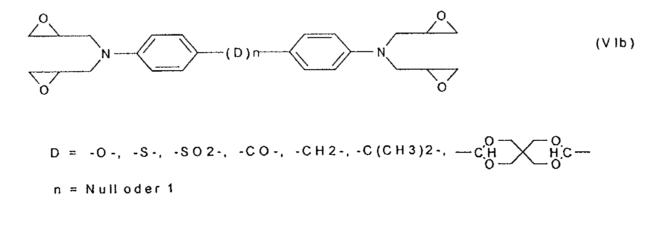 oder der Formel (VIc): 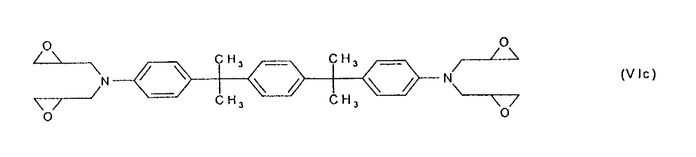 oder der Formel (VId): 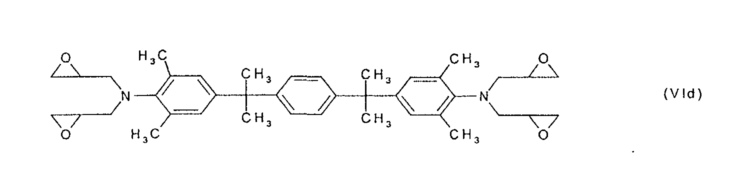 enthält.

25. Vergussmasse nach einem der Ansprüche 1-24, **dadurch gekennzeichnet, dass** diese als Härter eine hydroxylhaltige Verbindung und/oder ein carboxylhaltiges Polymer, vorzugsweise einen carboxylterminierten Polyester und/oder ein carboxylhaltiges Acrylat- und/oder Methacrylatpolymer und/oder ein Carbonsäureanhydrid enthält.

26. Vergussmasse nach Anspruch 25, **dadurch gekennzeichnet, dass** diese als Härter ein Anhydrid von aromatischen, aliphatischen, cycloaliphatischen, vorzugsweise cis-Cyclohexan-1,2-dicarbonsäureanhydrid, und heterocyclischen Polycarbonsäuren, vorzugsweise ein Anhydrid von aromatischen Polycarbonsäuren, vorzugsweise Phthalsäureanhydrid und deren substituierte Derivate, Benzol-1,2,4,5-tetracarbonsäuredianhydrid und deren substituierte Derivate, und/oder eine Verbindung der Formel (VII): 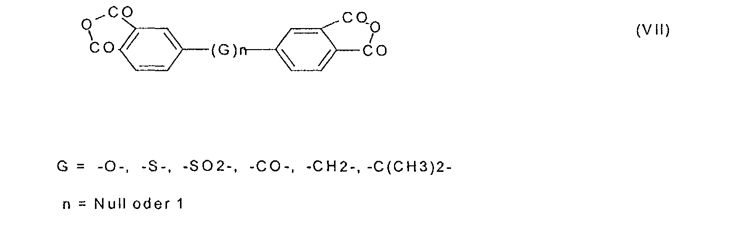 enthält.

27. Verfahren zur Herstellung einer Vergussmasse nach einem der Ansprüche 1-26, **dadurch gekennzeichnet, dass** man das Epoxidharz, den Härter, und die Siloxanverbindung, das Fluorotensid, sowie gegebenenfalls anwesende Additive, in beliebiger Reihenfolge mischt.

28. Verwendung einer Vergussmasse nach den Ansprüchen 1-26 für die Herstellung von Hochspannungsisolierung für den Freilufteinsatz, insbesondere für die Herstellung von Freiluftisolatoren bei Hochspannungsleitungen als Langstab-, Verbund- und Kappenisolatoren oder für Stützisolatoren im Mittelspannungsbereich, für Isolierungen bei Freiluft-Leistungschaltern, Messwandlern, Durchführungen und Ableitern, im Schaltanlagenbau, in Leistungsschaltern, Trockentransformatoren und elektrischen Maschinen.

29. Verwendung einer Vergussmasse nach den Ansprüchen 1-26 als Beschichtungsmaterialien für Transistoren und andere Halbleiterelemente, zum Imprägnieren von elektrischen Bauteilen, als Klebstoff, als Matrixharz für faserverstärkte Kunststoffe oder als Korrosionsschutz für metallische Bauteile.

30. Die gemäss den Ansprüchen 28 und 29 hergestellten elektrischen Isolierungen und Bauteile.
